# EUROPÄISCHE PATENTSCHRIFT

(11) **EP 2 327 110 B1**
(45) Veröffentlichungstag und Bekanntmachung des Hinweises auf die Patenterteilung: **26.12.2018**
(21) Anmeldenummer: 09736562.1
(22) Anmeldetag: 20.08.2009
(51) Int. Cl.: H01L 33/48, H01L 33/64, H01L 33/00, H01L 25/075, H01L 33/62

(54) **OPTOELEKTRONISCHES BAUTEIL UND VERFAHREN ZUR HERSTELLUNG EINES OPTOELEKTRONISCHEN BAUTEILS**
OPTOELECTRONIC COMPONENT, AND METHOD FOR THE PRODUCTION OF AN OPTOELECTRONIC COMPONENT
COMPOSANT OPTOELECTRONIQUE ET SON PROCÉDÉ DE PRODUCTION

(30) Priorität: 04.09.2008 DE 102008045925
(43) Veröffentlichungstag der Anmeldung: 01.06.2011
(73) Patentinhaber: OSRAM Opto Semiconductors GmbH, 93055 Regensburg (DE)
(72) Erfinder: GRÖTSCH, Stefan, 93077 Lengfeld - Bad Abbach (DE); ZEILER, Thomas, 93152 Nittendorf (DE); ZITZLSPERGER, Michael, 93047 Regensburg (DE); JÄGER, Harald, 93049 Regensburg (DE)
(74) Vertreter: Epping - Hermann - Fischer
(86) Internationale Anmeldenummer: PCT/DE2009/001183
(87) Internationale Veröffentlichungsnummer: WO 2010/025701

(56) Entgegenhaltungen:
- WO-A1-00/55914
- WO-A1-2008/038708
- DE-A1-102007 033 057
- US-A1- 2006 197 101
- US-A1- 2008 179 620

## Beschreibung

Es wird ein optoelektronisches Bauteil angegeben. Optoelektronische Bauelemente und Verfahren zu deren Herstellung sind beispielsweise in den Druckschriften DE 102007033057 A1, US 2008/0179620 A1, WO 00/55914 A1, US 2006/197101 A1 und WO 2008/038708 A1 beschrieben.

Eine zu lösende Aufgabe besteht darin, ein optoelektronisches Bauteil anzugeben, welches sich durch eine besonders gute Wärmeableitung auszeichnet. Eine weitere zu lösende Aufgabe besteht darin, ein Verfahren zur Herstellung eines solchen Bauteils anzugeben, das besonders kostengünstig ist.

Gemäß zumindest einer Ausführungsform des optoelektronischen Bauteils weist das optoelektronische Bauteil zumindest zwei Anschlussstellen auf, die zur elektrischen Kontaktierung des Bauteils dienen. Das heißt, mittels der Anschlussstellen, kann das elektrische Bauteil von außerhalb des Bauteils elektrisch kontaktiert werden. Die Anschlussstellen sind elektrisch leitend mit wenigstens einem Halbleiterchip des optoelektronischen Bauteils verbunden, der auf diese Weise mittels der Anschlussstellen bestromt werden kann. Dabei ist es möglich, dass das elektrische Bauteil zwei, vier oder mehr Anschlussstellen aufweist.

Gemäß zumindest einer Ausführungsform des optoelektronischen Bauteils umfasst das optoelektronische Bauteil einen Gehäusekörper. Die Anschlussstellen des optoelektronischen Bauteils sind in den Gehäusekörper stellenweise eingebettet.

"Stellenweise eingebettet" bedeutet dabei, dass die Anschlussstellen je einen Bereich - den Gehäuse-Abschnitt - aufweisen, in dem sie vom Gehäusekörper umgeben sind. In diesem Gehäuse-Abschnitt grenzt das Gehäusematerial direkt an die Anschlussstelle. Darüber hinaus weisen die Anschlussstellen vorzugsweise je einen Anschluss-Abschnitt auf, welcher sich außerhalb des Gehäusekörpers befindet. In diesem Anschluss-Abschnitt sind die Anschlussstellen beispielsweise von allen Seiten frei zugänglich und insbesondere frei vom Gehäusematerial. Die Anschlussstellen können darüber hinaus je einen chipseitigen Abschnitt aufweisen, welcher einem Halbleiterchip des optoelektronischen Bauteils zugewandt ist. In ihrem chipseitigen Abschnitt liegen die Anschlussstellen zumindest teilweise frei, das heißt, sie sind zumindest stellenweise nicht vom Gehäusekörper bedeckt. Im chipseitigen Abschnitt können die Anschlussstellen elektrisch leitend mit einem Halbleiterchip des optoelektronischen Bauteils verbunden sein.

Gemäß zumindest einer Ausführungsform des optoelektronischen Bauteils umfasst das Bauteil ferner einen Kühlkörper, der mit zumindest einer Anschlussstelle verbunden ist. Das heißt, der Kühlkörper ist mechanisch fest mit zumindest einer Anschlussstelle verbunden. Dabei kann der Kühlkörper auch elektrisch leitend mit der Anschlussstelle verbunden sein. Der Kühlkörper liegt dann auf demselben elektrischen Potenzial wie die Anschlussstelle, mit der er verbunden ist.

Bei dem Kühlkörper handelt es sich beispielsweise um einen plattenartigen Körper, der aus einem gut wärmeleitfähigen Material wie einem Metall, einem keramischen Material oder einem dotierten Halbleitermaterial bestehen kann. Insbesondere ist es möglich, dass der Kühlkörper aus dem gleichen Material wie die Anschlussstelle, beispielsweise einem Metall, besteht. Der Kühlkörper nimmt von einem optoelektronischen Halbleiterchip des Bauteils im Betrieb erzeugte Wärme auf und gibt diese Wärme in Bereiche außerhalb des optoelektronischen Bauteils ab.

Gemäß zumindest einer Ausführungsform des optoelektronischen Bauteils ist der Gehäusekörper mit einem Kunststoffmaterial gebildet. Dabei ist es insbesondere möglich, dass der Gehäusekörper aus einem Kunststoffmaterial besteht. In das Kunststoffmaterial des Gehäusekörpers können weitere Materialien eingebracht sein. Beispielsweise können in das Kunststoffmaterial strahlungsreflektierende, wärmeleitende oder strahlungsabsorbierende Partikel eingebracht sein. Darüber hinaus kann der Kunststoffkörper Zusätze enthalten, welche eine Haftung des Gehäusekörpers an den Anschlussstellen, welche stellenweise in den Gehäusekörper eingebettet sind, verbessern.

Gemäß zumindest einer Ausführungsform des optoelektronischen Bauteils weist der Gehäusekörper eine Öffnung auf, in welcher der Kühlkörper stellenweise frei zugänglich ist. Das heißt, in dem Gehäusekörper ist eine Ausnehmung, ein Durchbruch oder ein Fenster gebildet, in welchem der Kühlkörper frei liegt. Der Kühlkörper liegt dabei stellenweise an seiner Deckfläche frei. Der Kühlkörper weist an seiner Deckfläche jedoch auch Bereiche, außerhalb der Öffnung des Gehäusekörpers, auf, in denen er vom Gehäusekörper bedeckt ist. In diesen Bereichen liegt der Kühlkörper dann nicht frei, er ist dort nicht frei zugänglich. Die frei zugänglichen Stellen auf der Deckfläche des Kühlkörpers sind vom Gehäusekörper zum Beispiel seitlich umschlossen.

Gemäß zumindest einer Ausführungsform des optoelektronischen Bauteils ist zumindest ein optoelektronischer Halbleiterchip in der Öffnung auf dem Kühlkörper angeordnet. Der optoelektronische Halbleiterchip kann dabei mittels eines Klebstoffs oder eines Lotmaterials auf dem Kühlkörper befestigt sein. Es ist auch möglich, dass der optoelektronische Halbleiterchip mit dem Kühlkörper elektrisch leitend verbunden ist. In diesem Fall liegt der Kühlkörper vorzugsweise auf demselben Potenzial, wie die Anschlussstelle, mit der er verbunden ist.

Bei dem optoelektronischen Halbleiterchip handelt es sich beispielsweise um einen Lumineszenzdiodenchip, das heißt einen Laserdiodenchip oder einen Leuchtdiodenchip. Darüber hinaus ist es möglich, dass es sich bei dem optoelektronischen Halbleiterchip um eine Fotodiode handelt, welche im Betrieb zur Detektion von elektromagnetischer Strahlung vorgesehen ist.

Gemäß zumindest einer Ausführungsform des optoelektronischen Bauteils weisen zumindest zwei der Anschlussstellen je einen chipseitigen Abschnitt auf, der dem zumindest einen Halbleiterchip zugewandt ist. Das heißt, zumindest zwei der Anschlussstellen weisen einen chipseitigen Abschnitt auf, in welchem sie teilweise frei liegen - also nicht vom Gehäusekörper bedeckt und in diesem eingebettet sind. In diesem Abschnitt können sie mit dem zumindest einen Halbleiterchip elektrisch leitend verbunden werden. Der Halbleiterchip sowie auch die chipseitigen Abschnitte der Anschlussstellen können von einem Vergussmaterial bedeckt sein, das für die vom Halbleiterchip im Betrieb erzeugte oder zu detektierende Strahlung zumindest teilweise durchlässig ist.

Die Anschlussstellen erstrecken sich ferner durch den Gehäusekörper, in dem sie in ihrem Gehäuse-Abschnitt eingebettet sind. Die Anschlussstellen durchbrechen den Gehäusekörper und liegen in ihrem sich den Gehäuse-Abschnitt anschließenden Anschluss-Abschnitt frei. Dort dienen die Anschlussstellen zur elektrischen Kontaktierung des optoelektronischen Bauteils.

Gemäß zumindest einer Ausführungsform des optoelektronischen Bauteils sind die chipseitigen Abschnitte der zumindest zwei Anschlussstellen, die je einen chipseitigen Abschnitt aufweisen, der dem zumindest einen optoelektronischen Halbleiterchip zugewandt ist, in einer gemeinsamen Ebene angeordnet. Das heißt, von den beiden chipseitigen Abschnitten liegt der eine nicht höher als der andere, sondern beide sind in einer Ebene angeordnet und überragen sich gegenseitig nicht. Die Ebene ist zum Beispiel durch die Deckfläche des Kühlkörpers gegeben oder verläuft parallel zur Deckfläche des Kühlkörpers.

Gemäß zumindest einer Ausführungsform des optoelektronischen Bauteils weist das optoelektronische Bauteil zumindest zwei Anschlussstellen zur elektrischen Kontaktierung des Bauteils auf. Ferner weist das Bauteil einen Gehäusekörper auf, in welchem die Anschlussstellen stellenweise eingebettet sind. Das optoelektronische Bauteil umfasst ferner einen Kühlkörper, der mit zumindest einer Anschlussstelle verbunden ist, wobei der Gehäusekörper mit einem Kunststoffmaterial gebildet ist, der Gehäusekörper eine Öffnung aufweist, in welcher der Kühlkörper stellenweise frei zugänglich ist, zumindest ein optoelektronischer Halbleiterchip in der Öffnung auf dem Kühlkörper angeordnet ist, und zumindest zwei der Anschlussstellen je einen chipseitigen Abschnitt aufweisen, der dem zumindest einen optoelektronischen Halbleiterchip zugewandt ist, wobei die chipseitigen Abschnitte der zumindest zwei Anschlussstellen in einer gemeinsamen Ebene angeordnet sind.

Insgesamt zeichnet sich ein solches optoelektronisches Bauteil dadurch aus, dass es zum einen besonders einfach herstellbar ist. Beispielsweise können die Anschlussstellen des optoelektronischen Bauteils bei der Herstellung des Bauteils im Trägerstreifen-Verbund vorliegen. Ein Trägerstreifenverbund, bei dem die chipseitigen Abschnitte der Anschlussstellen in einer gemeinsamen Ebene angeordnet sind, ist dabei besonders einfach zu verarbeiten. Das optoelektronische Bauteil kann dadurch in einem kontinuierlichen Verfahren wie beispielsweise in einem von "Rolle-zu-Rolle"-Verfahren hergestellt werden.

Der Kühlkörper, der zumindest mit einer der Anschlussstellen verbunden ist, ermöglicht ein optoelektronisches Bauteil, bei dem vom optoelektronischen Halbleiterchip erzeugte Wärme besonders effizient abgeführt werden kann.

Aufgrund der Tatsache, dass der Kühlkörper die vom optoelektronischen Halbleiterchip erzeugte Wärme besonders effizient abführt, ist als Gehäusekörper die Verwendung eines einfachen Kunststoffmaterials ermöglicht, wobei - aufgrund der guten Wärmeableitung durch den Kühlkörper - keine hohen Anforderungen an die Temperaturstabilität des Kunststoffmaterials für den Gehäusekörper zu stellen sind. Insbesondere kann auf ein teures Keramikmaterial als Gehäusekörper in diesem Fall verzichtet werden.

Die Verwendung eines Kunststoffmaterials ermöglicht darüber hinaus eine geeignete und technisch einfach realisierbare Formgebung des Gehäusekörpers, beispielsweise mittels Spritzgießen.

Gemäß zumindest einer Ausführungsform des optoelektronischen Bauteils handelt es sich bei dem Kunststoffmaterial des Gehäusekörpers um ein Epoxidharz. Das heißt, der Gehäusekörper besteht aus oder enthält Epoxidharz.

Gemäß zumindest einer Ausführungsform des optoelektronischen Bauteils besteht das Kunststoffmaterial des Gehäusekörpers aus Silikon oder es enthält Silikon.

Darüber hinaus ist es möglich, dass das Kunststoffmaterial des Gehäusekörpers ein Silikon-Epoxidharz-Hybridmaterial ist. Beispielsweise kann dieses Hybridmaterial 50 % Epoxidharz und 50 % Silikon aufweisen. Ferner kann das Kunststoffmaterial Füllstoffe enthalten, die zur Verringerung des thermischen Ausdehnungskoeffizienten und / oder als Haftvermittler dienen.

Die genannten Kunststoffmaterialien zeichnen sich durch eine einfache Verarbeitbarkeit und damit durch eine kostengünstige Herstellung des optoelektronischen Bauteils aus. Darüber hinaus ist insbesondere Silikon besonders resistent gegen vom optoelektronischen Bauteil erzeugte elektromagnetische Strahlung.

Gemäß zumindest einer Ausführungsform des optoelektronischen Bauteils weist der Kühlkörper eine Deckfläche auf, auf die der zumindest eine optoelektronische Halbleiterchip aufgebracht ist. Der Kühlkörper weist darüber hinaus eine Bodenfläche auf, die der Deckfläche abgewandt ist. Mit der Bodenfläche des Kühlkörpers kann das optoelektronische Bauteil auf einer Montagefläche für das Bauteil befestigt sein. Die vom optoelektronischen Halbleiterchip erzeugte Wärme wird dann besonders effizient von der Deckfläche zur Bodenfläche und von dort auf die Montagefläche abgegeben. Darüber hinaus weist der Kühlkörper zumindest eine Seitenfläche auf, welche die Deckfläche und die Bodenfläche miteinander verbindet.

Beispielsweise ist der Kühlkörper quaderartig ausgebildet. Die Seitenfläche des Kühlkörpers ist dann durch eine Seitenfläche des Quaders gegeben.

Zum Beispiel ist die Seitenfläche dabei frei vom Kunststoffmaterial des Gehäusekörpers. Das heißt, der Kühlkörper muss nicht vollständig vom Gehäusematerial umgeben sein, es ist möglich, dass zumindest eine Seitenfläche oder auch sämtliche Seitenflächen des Kühlkörpers frei vom Gehäusekörper sind. In diesem Fall ist dann auch die Bodenfläche des Kühlkörpers frei vom Gehäusekörper. Auf diese Weise kann der Kühlkörper vom optoelektronischen Halbleiterchip im Betrieb erzeugte Wärme besonders effizient an die Umgebung abgeben, da die Wärme nicht durch das Kunststoffmaterial des Gehäusekörpers geführt werden muss. Im Extremfall ist der Kühlkörper lediglich an seiner Deckfläche stellenweise vom Gehäusekörper bedeckt. Die restlichen Flächenabschnitte, insbesondere die Seitenflächen und die Bodenfläche des Kühlkörpers, sind dann frei vom Kunststoffmaterial des Gehäusekörpers.

Alternativ ist es auch möglich, dass der Kühlkörper an seinen Seitenflächen und seiner Bodenfläche vollständig vom Gehäusematerial bedeckt ist. In diesem Fall kann sich zwar eine verschlechterte Wärmeableitung ergeben, anderseits kann jedoch die Haftung zwischen Gehäusematerial und Kühlkörper verbessert sein.

Gemäß zumindest einer Ausführungsform des optoelektronischen Bauteils weist der Kühlkörper einen Befestigungs-Abschnitt auf. In diesem Befestigungs-Abschnitt kann der Kühlkörper mit einer Montagefläche für das optoelektronische Bauteil mechanisch verbunden werden. Vorzugsweise überragt der Befestigungs-Abschnitt des Kühlkörpers den Gehäusekörper lateral. Das heißt, der Kühlkörper ist in diesem Fall nicht bündig mit dem Gehäusekörper ausgebildet und wird vom Gehäusekörper auch nicht umlaufend lateral überragt, sondern an wenigstens einer Stelle - dem Befestigungs-Abschnitt des Kühlkörpers - überragt der Kühlkörper den Gehäusekörper lateral. Dies hat auch zur Folge, dass der Kühlkörper in diesem Fall eine vergrößerte Fläche aufweist, was die Wärmeabfuhr an die Umgebung weiter verbessert, da vom optoelektronischen Halbleiterchip erzeugte Wärme über eine größere Fläche abgegeben werden kann.

Gemäß zumindest einer Ausführungsform des optoelektronischen Bauteils weist der Kühlkörper im Befestigungs-Abschnitt eine Öffnung auf, die zur Aufnahme eines Befestigungsmittels vorgesehen ist. Bei der Öffnung kann es sich beispielsweise um eine Ausnehmung, einen Durchbruch, eine Aussparung oder eine Bohrung handeln. In die Öffnung kann ein Befestigungsmittel eingreifen. Bei dem Befestigungsmittel handelt es sich beispielsweise um eine Klemmvorrichtung oder einen Passstift oder eine Schraube. Das Befestigungsmittel greift in die Öffnung des Kühlkörpers ein und verbindet den Kühlkörper und damit das gesamte optoelektronische Bauteil mechanisch fest mit einer Montagefläche für das optoelektronische Bauteil.

Gemäß zumindest einer Ausführungsform des optoelektronischen Bauteils ist zumindest eine Anschlussstelle in ihrem dem chipseitigen Abschnitt abgewandten Anschluss-Abschnitt als Lötfahne ausgebildet. Das heißt, das optoelektronische Bauteil weist dann zum elektrischen Anschließen eine Lötöse mit zumindest einer Lötfahne auf. Dies erweist sich insbesondere in Verbindung mit einem Kühlkörper, der den Gehäusekörper in einem Befestigungs-Abschnitt lateral überragt und im Befestigungs-Abschnitt eine Öffnung aufweist, die zur Aufnahme eines Befestigungsmittels vorgesehen ist, als besonders vorteilhaft. In diesem Fall kann der elektrische Anschluss - über die Anschlussstelle - vom mechanischen Befestigen des optoelektronischen Bauteils - über den Befestigungs-Abschnitt des Kühlkörpers - entkoppelt sein.

Alternativ zu einer Lötfahne ist es auch möglich, dass der Anschluss-Abschnitt der Anschlussstelle als Stecker für eine Steckverbindung ausgebildet ist. In diesem Fall kann das optoelektronische Bauteil über eine reversible Steckverbindung elektrisch angeschlossen sein. Reversibel heißt dabei, dass der elektrische Anschluss zerstörungsfrei hergestellt und unterbrochen werden kann.

Die in ihrem Anschluss-Abschnitt als Lötfahne oder Stecker einer Steckverbindung ausgebildete Anschlussstelle kann insbesondere quer zum Befestigungs-Abschnitt des Kühlkörpers verlaufen. Beispielsweise schließen die Haupterstreckungsrichtung des Befestigungs-Abschnitts und die Haupterstreckungsrichtung der Anschlussstelle dann einen spitzen Winkel oder einen 90°-Winkel miteinander ein. Dies erleichtert die Entkopplung von mechanischer und elektrischer Kontaktierung des optoelektronischen Bauteils.

Gemäß zumindest einer Ausführungsform des optoelektronischen Bauteils weist das optoelektronische Bauteil wenigstens drei Anschlussstellen auf. Vorzugsweise weist das optoelektronische Bauteil dann eine Anzahl von Anschlussstellen auf, die zweimal die Anzahl der im optoelektronischen Bauteil vorhandenen optoelektronischen Halbleiterchips beträgt. Das heißt, sind im optoelektronischen Bauteil beispielsweise vier Halbleiterchips angeordnet, so kann das optoelektronische Bauteil acht Anschlussstellen aufweisen. Dies ermöglicht es dann, jeden der optoelektronischen Halbleiterchips getrennt von den anderen optoelektronischen Halbeiterchips des optoelektronischen Bauteils anzusteuern.

Dabei ist es möglich, dass zumindest zwei der Anschlussstellen mit dem Kühlkörper verbunden, beispielsweise verschweißt sind. Die Anschlussstellen, welche mit dem Kühlkörper verbunden sind, befinden sich vorzugsweise auf demselben elektrischen Potenzial wie der Kühlkörper. Weist das optoelektronische Bauteil beispielsweise acht Anschlussstellen auf, so sind vorzugsweise vier der Anschlussstellen elektrisch leitend mit dem Kühlkörper verbunden und mit diesem verschweißt. Die Halbleiterchips des optoelektronischen Bauteils können dann über den Kühlkörper beispielsweise n-seitig elektrisch kontaktiert sein. Jedem der optoelektronischen Halbleiterchips ist eine Anschlussstelle zugeordnet, die nicht mit dem Kühlkörper verbunden ist und über welche der optoelektronische Halbleiterchip p-seitig kontaktiert werden kann. Ganz allgemein kann zum Beispiel die Hälfte aller Anschlussstellen mechanisch fest und elektrisch leitend mit dem Kühlkörper verbunden sein. Die andere Hälfte der Anschlussstellen ist dann nicht elektrisch leitend mit dem Kühlkörper verbunden, sondern von diesem elektrisch isoliert.

Ein derartiger Aufbau zeichnet sich - aufgrund der Verbindung von relativ vielen Anschlussstellen mit dem Kühlkörper - durch eine besonders hohe mechanische Stabilität aus.

Gemäß zumindest einer Ausführungsform des optoelektronischen Bauteils weist das optoelektronische Bauteil vier oder mehr Halbleiterchips auf. Die optoelektronischen Halbleiterchips sind auf die Deckfläche des Kühlkörpers aufgebracht. Eine so hohe Anzahl optoelektronischer Halbleiterchips ist vorliegend möglich, da die von den optoelektronischen Halbleiterchips im Betrieb erzeugte Wärme über den Kühlkörper besonders effizient nach außen abgegeben werden kann.

Gemäß zumindest einer Ausführungsform weist der Kühlkörper eine Grundfläche auf, welche wenigstens 90 % der Grundfläche des Gehäusekörpers beträgt. Dabei ist es auch möglich, dass der Kühlkörper eine größere Grundfläche aufweist als der Gehäusekörper. Ein solch großer Kühlkörper zeichnet sich dadurch aus, dass die von den optoelektronischen Halbleiterchips des Bauteils im Betrieb erzeugte Wärme auf eine besonders große Fläche verteilt werden kann.

Es wird ferner ein Verfahren zur Herstellung eines optoelektronischen Bauteils angegeben. Vorzugsweise ist ein optoelektronisches Bauteil wie es hier beschrieben ist, mittels des Verfahrens herstellbar. Das heißt die in Verbindung mit dem optoelektronischen Bauteil offenbarten Merkmale sind auch für das hier beschriebene Verfahren offenbart.

Gemäß zumindest einer Ausführungsform des Verfahrens zur Herstellung eines optoelektronischen Bauteils umfasst das Bauteil folgende Verfahrensschritte in der folgenden Reihenfolge:
- Bereitstellen von zumindest zwei Anschlussstellen,
- Verbinden von zumindest einer Anschlussstelle mit einem Kühlkörper,
- Erzeugen eines Gehäusekörpers, in welchem die Anschlussstellen stellenweise eingebettet sind, wobei im Gehäusekörper eine Öffnung zum Kühlkörper vorgesehen wird, und
- Befestigung zumindest eines optoelektronischen Halbleiterchips in der Öffnung des Gehäusekörpers auf dem Kühlkörper.

Das heißt, bei dem beschriebenen Verfahren wird der Gehäusekörper vor der Befestigung der Halbleiterchips auf dem Kühlkörper erzeugt. Im Gehäusekörper wird eine Öffnung frei gelassen, in welchem die Deckfläche des Kühlkörpers frei zugänglich ist. In diese Öffnung werden die Halbleiterchips nach Herstellung des Gehäusekörpers dann eingebracht. Der Gehäusekörper kann dabei beispielsweise mittels eines Spritzguss- oder Spritzpressverfahrens erzeugt werden.

Gemäß einer Ausführungsform des hier beschriebenen Verfahrens sind die Anschlussstellen während des Verfahrens in einem Trägerstreifen-Verbund angeordnet. Das heißt, die Anschlussstellen liegen in einem Trägerstreifen (auch: Leadframe oder Leiterrahmen)-Verbund vor. Die Anschlussstellen können daher in einem kontinuierlichen, beispielsweise in einem Rolle-zu-Rolle-Verfahren (reel to reel), verarbeitet werden.

Beispielsweise wird bei der Fertigung der optoelektronischen Bauteile zunächst ein Kühlkörper mit einer bestimmten Anzahl von Anschlussstellen mechanisch verbunden. Dies kann durch Punktschweißen geschehen. Anschließend wird für jedes optoelektronische Bauteil ein Gehäusekörper derart gefertigt, dass die Anschlussstellen des zu fertigenden Bauteils stellenweise im Gehäusekörper eingebettet sind. Daraufhin werden die optoelektronischen Halbleiterchips für jedes Bauteil in einer Öffnung des Gehäusekörpers auf dem zugeordneten Kühlkörper montiert. Schließlich kann eine Vereinzelung des Trägerstreifenverbunds zu einzelnen optoelektronischen Bauteilen erfolgen.

Im Folgenden wird das hier beschriebene optoelektronische Bauteil anhand von Ausführungsbeispielen und den dazugehörigen Figuren näher erläutert.
- Die Figur 1A: zeigt ein erstes Ausführungsbeispiel eines hier beschriebenen optoelektronischen Bauteils in einer schematischen Perspektivdarstellung.
- Die Figur 1B: zeigt eine schematische Schnittdarstellung des ersten Ausführungsbeispiels eines hier beschriebenen optoelektronischen Bauteils.
- Die Figur 2: zeigt eine schematische Perspektivdarstellung eines zweiten Ausführungsbeispiels eines hier beschriebenen optoelektronischen Bauteils.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

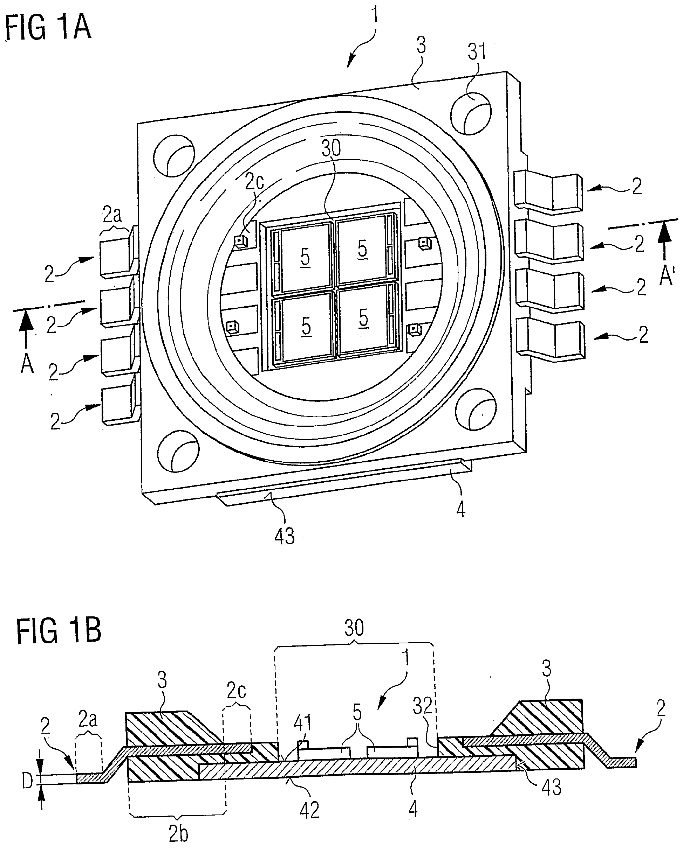

Das in Verbindung mit der Figur 1A beschriebene optoelektronische Bauteil 1 weist vier optoelektronische Halbleiterchips 5 auf. Bei den optoelektronischen Halbleiterchips 5 handelt es sich vorliegend um Leuchtdiodenchips. Die optoelektronischen Halbleiterchips 5 sind auf die Deckfläche 41 eines Kühlkörpers 4 aufgebracht. Der Kühlkörper 4 besteht vorliegend aus einem Metall wie Kupfer oder Aluminium.

Der Kühlkörper 4 kann darüber hinaus bei den hier beschriebenen optoelektronischen Bauteilen besonders Dick ausgeführt werden. Zum Beispiel ist eine Dicke D zwischen 0,8 mm und 2,0 mm, insbesondere im Bereich von 1,2 mm bis 1,6 mm möglich. Der Kühlkörper 4 besteht dann vorzugsweise aus Kupfer, was sich durch seine gute Wärmeleitfähigkeit und die relativ geringen Kosten auszeichnet.

Das optoelektronische Bauteil 1 umfasst darüber hinaus acht Anschlussstellen 2. Jede der Anschlussstellen 2 umfasst einen Anschluss-Abschnitt 2a, über welchen das optoelektronische Bauteil 1 elektrisch anschließbar ist. Ferner weist jede der Anschlussstellen 2 einen Gehäuseabschnitt 2b auf, in welchem die Anschlussstellen 2 in das Material des Gehäusekörpers 3 eingebettet sind. Darüber hinaus weist jede der Anschlussstellen 2 einen chipseitigen Abschnitt 2c auf. Die chipseitigen Abschnitte 2c sind stellenweise vom Gehäusematerial 3 unbedeckt und den optoelektronischen Halbleiterchips 5 zugewandt. Sämtliche chipseitigen Abschnitte 2c sind in einer gemeinsamen Ebene angeordnet. Das heißt, keine der Anschlussstellen überragt die andere im Bereich der chipseitigen Abschnitte 2c. Der Gehäusekörper weist eine Öffnung 30 auf, in welcher der Kühlkörper 4 frei zugänglich ist. In dieser Öffnung 30 sind die optoelektronischen Halbleiterchips 5 auf dem Kühlkörper angeordnet.

Die Öffnung 30 kann dabei relativ groß ausgebildet sein. So kann die Öffnung 30 das Dreifache oder mehr der Summe der Chipflächen der optoelektronischen Halbleiterchips 5 betragen. Findet ein einziger optoelektronischen Halbleiterchip 5 Verwendung, so kann die Größe der Öffnung 30 zum Beispiel das Vierfache der Chipgröße betragen. Das Flächenverhältnis zwischen Öffnung 30 und Summe der Chipflächen wird umso kleiner, je mehr Chips auf dem Kühlköper montiert sind.

Die äußersten Anschlussstellen 2 auf jeder Seite des optoelektronischen Bauteils 1 sind mit dem Kühlkörper 4 mechanisch verbunden. Beispielsweise sind diese Anschlussstellen 2 mittels Punktschweißen mit dem Kühlkörper verbunden. Die verbleibenden Anschlussstellen sind vom Kühlkörper elektrisch entkoppelt. Beispielsweise kann sich Material des Gehäusekörpers 3 in diesen Bereichen zwischen Kühlkörper 4 und Anschlussstelle 2 befinden, siehe Figur 1B.

Ferner weist der Gehäusekörper 3 vier Ausnehmungen 31 auf. Die Ausnehmungen 31 dienen zur Aufnahme von Passstiften oder Schrauben, mit deren Hilfe das optoelektronische Bauteile auf einer Montagefläche justiert und/oder befestigt werden kann.

Als Gehäusematerial für den Gehäusekörper 3 kommt vorzugsweise ein Kunststoffmaterial zur Verwendung. Beispielsweise kann Epoxidharz, ein Hybridmaterial aus Silikon und Epoxidharz oder eine Silikon-Pressmasse Verwendung finden. Das Gehäusematerial kann darüber hinaus Füllstoffe enthalten, welche die mechanischen und optischen Eigenschaften des Materials und gegebenenfalls die Haftung zu einem Vergussmaterial (nicht dargestellt), mit dem die optoelektronischen Halbleiterchips vergossen sind, enthalten. Darüber hinaus kann das Gehäusematerial Füllstoffe enthalten, welche eine Haftung an den Anschlussstellen 2 verbessern. Der Gehäusekörper 3 dient als Umhüllung für die Anschlussstellen 2 und bildet zusammen mit dem Kühlkörper 4 das Gehäuse des optoelektronischen Bauteils.

Zum Einstellen der mechanischen Eigenschaften des Gehäusekörpers 3 kann das Gehäusematerial zum Beispiel Glasfasern und / oder anorganische Füllstoffe enthalten.

Die optoelektronischen Halbleiterchips in der Öffnung 30 des Gehäusematerials sind geeignet, elektromagnetische Strahlung im Wellenbereich von ultravioletter Strahlung bis zu Infrarot zu emittieren. Beispielsweise handelt es sich bei den optoelektronischen Halbleiterchips um blaues oder ultraviolettes Licht emittierende Leuchtdiodenchips. Den optoelektronischen Halbleiterchips ist dann ein Lumineszenzkonversionsmaterial nachgeordnet, welches zumindest einen Teil der erzeugten Strahlung in Licht einer anderen Wellenlänge umwandelt. Auf diese Weise kann vom optoelektronischen Bauteil insbesondere auch weißes Mischlicht emittiert werden.

Der Gehäusekörper 3 kann dabei schwarz gestaltet sein. Beispielsweise kann das Gehäusematerial Ruß enthalten, um den Gehäusekörper 3 strahlungsabsorbierend auszubilden.

Darüber hinaus ist es auch möglich, dass der Gehäusekörper 3 aus einem klaren Kunststoffmaterial gebildet ist, welches durchsichtig ist.

Ferner kann der Gehäusekörper 3 beispielsweise durch die Zugabe geeigneter Füllstoffpartikel - die zum Beispiel Titanoxid umfassen können - reflektierend oder weiß ausgebildet sein.

Der Gehäusekörper 3 weist den optoelektronischen Halbleiterchips 5 zugewandt eine umlaufende Wand 32 auf. Die umlaufende Wand 32 sorgt dafür, dass von den Halbleiterchips 5 seitlich emittierte Strahlung, welche beispielsweise nicht durch ein Lumineszenzkonversionsmaterial umgewandelt wurde, abgeschattet wird. Das Lumineszenzkonversionsmaterial kann sich in diesem Fall auf der dem Kühlkörper 4 abgewandten Oberseite der Halbleiterchips 5 befinden.

Bei den optoelektronischen Halbleiterchips kann es sich beispielsweise um Halbleiterchips in Dünnfilmbauweise handeln, bei denen ein Aufwachssubstrat entfernt oder zumindest gedünnt wurde. Solche so genannten Dünnfilm-Chips zeichnen sich unter anderem auch dadurch aus, dass sie den überwiegenden Teil der im Betrieb erzeugten elektromagnetischen Strahlung lediglich durch ihre Oberseite abgeben. An den Seitenflächen emittieren diese Dünnfilm-Chips kaum oder gar keine elektromagnetische Strahlung.

Zum Schutz des Gehäusekörpers 3 vor von den optoelektronischen Halbleiterchips 5 erzeugter elektromagnetischer Strahlung kann der Gehäusekörper an Stellen, wo elektromagnetische Strahlung auftreffen kann, ferner verspiegelt sein oder durch eine Beschichtung oder eine Folie geschützt werden.

Im Gehäusekörper 3 integriert, das heißt vom Gehäusematerial vergossen oder umgeben, können sich beispielsweise weitere, nicht optoelektronische Bauelemente befinden. Beispielsweise kann es sich bei diesen Bauelementen um ESD-Schutzdioden, Varistoren, Temperatursensoren und/oder eine Regel- und Steuerelektronik handeln.

Ferner kann das optoelektronische Bauteil sowohl strahlungsemittierende als auch strahlungsempfangende optoelektronische Halbleiterchips 5 enthalten. Das Bauteil ist dann beispielsweise zur Bildung einer Reflexlichtschranke vorgesehen. Das optoelektronische Bauteil kann insbesondere in diesem Fall im Gehäusekörper 3 mehrere Öffnungen 30 enthalten. So können dann Detektorchips, wie beispielsweise Fotodioden und Emitterchips, wie beispielsweise Laser- oder Leuchtdioden, in unterschiedlichen Öffnungen 30 des Gehäusekörpers 3 angeordnet sein. Durch das zwischen ihnen angeordnete Material des Gehäusekörpers 3 sind die Chips optisch voneinander entkoppelt.

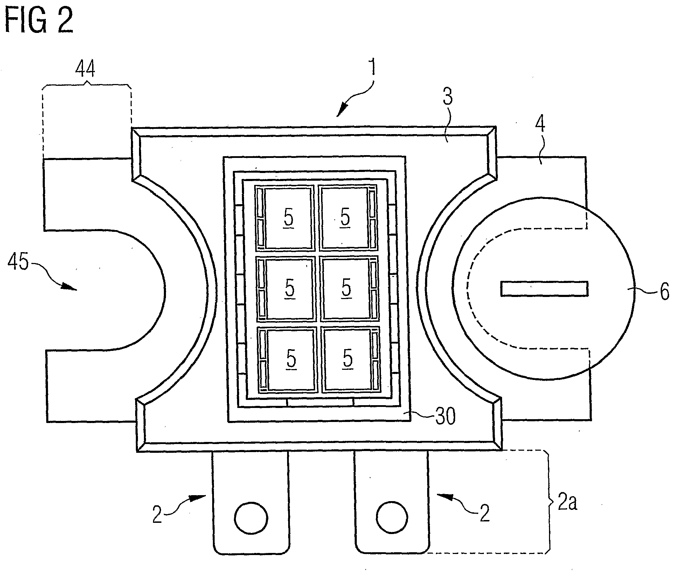

In Verbindung mit der Figur 2 ist anhand einer schematischen Perspektivdarstellung ein weiteres Ausführungsbeispiel eines hier beschriebenen optoelektronischen Bauteils näher erläutert. In diesem Ausführungsbeispiel weist der Kühlkörper 4 eine größere Grundfläche als der Gehäusekörper 3 auf. Der Kühlkörper 4 weist Befestigungs-Abschnitte 44 auf, welche den Gehäusekörper lateral überragen. In den Befestigungs-Abschnitten 44 sind Öffnungen 45 angeordnet, welche zur Aufnahme eines Befestigungsmittels 6 dienen. Bei dem Befestigungsmittel 6 handelt es sich beispielsweise um eine Schraube, mit der das optoelektronische Bauteil auf einer Montagefläche mechanisch befestigt werden kann. Alternativ kann das Bauteil beispielsweise auf eine Montagefläche aufgeklemmt werden.

Das Bauteil weist darüber hinaus zwei Anschlussstellen 2 auf, welche jeweils als Lötfahnen ausgebildet sind. Die mechanische Befestigung des Bauteils mittels der Befestigungs-Abschnitte 44 des Kühlkörpers 4 ist von der elektrischen Kontaktierung mittels der Lötfahnen der Anschlussstelle 2 entkoppelt. Die Anschlussstellen 2 sind derart angeordnet, dass sie quer zum Kühlkörper 4 verlaufen. Alternativ zu einer Lötfahne können die Anschlussstellen 2 auch als Stecker für eine Steckverbindung ausgebildet sein.

Insgesamt ist das optoelektronische Bauteil, wie es in Verbindung mit der Figur beschrieben ist, nicht als oberflächenmontierbares (SMT)-Bauteil ausgebildet. Insbesondere ist beim Bauteil, wie es in Verbindung mit der Figur 2 beschrieben ist, der Wärmeleitpfad über den Kühlkörper von der elektrischen Leitung über die Anschlussstellen 2 entkoppelt.

Die hier beschriebenen optoelektronischen Bauteile zeichnen sich insbesondere durch eine besonders preiswerte Herstellung und eine sehr effektive Entwärmung aus. Die Bauteile können in einem kontinuierlichen Rolle-zu-Rolle-Verfahren hergestellt werden. Sie weisen aufgrund des Kühlkörpers 4, welcher direkt mit den Halbleiterchips 5 verbunden ist und sehr großflächig ausgeführt werden kann, eine besonders gute Wärmeabfuhr auf.

Die Wärmesenke kann insbesondere beim Ausführungsbeispiel der Figur 2 elektrisch von den Anschlussstellen 2 entkoppelt sein. In diesem Fall ist zwischen Anschlussstellen 2 und Kühlkörper 4 Material des Gehäusekörpers 3 angeordnet. Eine mechanische Verbindung zwischen den Anschlussstellen 2 und dem Kühlkörper 4 erfolgt dabei beispielsweise über den Gehäusekörper 3, welcher den Kühlkörper 4 dann an dessen Seitenflächen und gegebenenfalls auch an dessen Bodenfläche 42 zumindest stellenweise oder vollständig bedecken kann. Die Erfindung ist nicht durch die Beschreibung anhand der Ausführungsbeispiele auf diese beschränkt. Vielmehr umfasst die Erfindung jedes Merkmal sowie jede Kombination von Merkmalen, in den Patentansprüchen. Diese Patentanmeldung beansprucht die Priorität der deutschen Patentanmeldung 102008045925.9.

## Patentansprüche

1. Optoelektronisches Bauteil (1) mit
- zumindest zwei Anschlussstellen (2) zur elektrischen Kontaktierung des Bauteils (1),
- einem Gehäusekörper (3), in welchem die Anschlussstellen (2) stellenweise eingebettet sind,
- einem Kühlkörper (4), der mit zumindest einer der Anschlussstellen (2) mechanisch fest verbunden ist, wobei
- sich der Kühlkörper (4) in einer ersten Ebene erstreckt,
- der Gehäusekörper (3) mit einem Kunststoffmaterial gebildet ist,
- der Gehäusekörper (3) eine Öffnung (30) aufweist, in welcher der Kühlkörper (4) stellenweise frei zugänglich ist,
- zumindest ein optoelektronischer Halbleiterchip (5) in der Öffnung (30) auf dem Kühlkörper (4) angeordnet ist, und
- zumindest zwei der Anschlussstellen (2) je einen chipseitigen Abschnitt (2c) aufweisen, der dem zumindest einen optoelektronischen Halbleiterchip (5) zugewandt ist, wobei die chipseitigen Abschnitte (2c) zumindest zwei der Anschlussstellen (2) vertikal über und mit dem Kühlkörper (4) zumindest teilweise überlappend in einer gemeinsamen zweiten Ebene angeordnet sind, wobei die zweite Ebene von der ersten Ebene verschieden ist und wobei der Kühlkörper (4) aufweist:
- eine Deckfläche (41), auf die der zumindest eine optoelektronische Halbleiterchip (5) aufgebracht ist,
- eine Bodenfläche (42), die der Deckfläche (41) abgewandt ist, und
- eine Seitenfläche (43), welche die Deckfläche (41) und die Bodenfläche (42) miteinander verbindet, wobei die Seitenfläche (43) frei vom Kunststoffmaterial des Gehäusekörpers (3) ist.

2. Optoelektronisches Bauteil gemäß dem vorherigen Anspruch, bei dem das Kunststoffmaterial des Gehäusekörpers (3) Epoxidharz ist oder Epoxidharz enthält.

3. Optoelektronisches Bauteil gemäß einem der vorherigen Ansprüche,
bei dem das Kunststoffmaterial des Gehäusekörpers (3) Silikon ist oder Silikon enthält.

4. Optoelektronisches Bauteil gemäß einem der vorherigen Ansprüche,
bei dem der Kühlkörper (4) ein plattenartiger Körper ist, der aus einem keramischen Material oder einem dotierten Halbleitermaterial besteht.

5. Optoelektronisches Bauteil gemäß einem der vorherigen Ansprüche,
bei dem der Kühlkörper (4) den Gehäusekörper (3) in einem Befestigungs-Abschnitt (44) des Kühlkörpers (4) lateral überragt.

6. Optoelektronisches Bauteil gemäß dem vorherigen Anspruch, bei dem der Kühlkörper (4) im Befestigungs-Abschnitt (44), eine Öffnung (45) aufweist, die zur Aufnahme eines Befestigungsmittels (6) vorgesehen ist.

7. Optoelektronisches Bauteil gemäß einem der vorherigen Ansprüche,
bei dem zumindest eine der Anschlussstellen (2) in einem ihrem chipseitigen Abschnitt (2c) abgewandten Anschluss-Abschnitt (2a) als Lötfahne ausgebildet ist.

8. Optoelektronisches Bauteil gemäß einem der vorherigen Ansprüche,
bei dem zumindest eine der Anschlussstellen (2) in einem ihrem chipseitigen Abschnitt (2c) abgewandten Anschluss-Abschnitt (2a) als Stecker für eine Steckverbindung ausgebildet ist.

9. Optoelektronisches Bauteil gemäß einem der vorherigen Ansprüche,
bei dem die zumindest eine der Anschlussstellen (2) in ihrem Anschluss-Abschnitt (2a) quer zum Befestigungs-Abschnitt (44) des Kühlkörpers (4) verläuft.

10. Optoelektronisches Bauteil gemäß einem der vorherigen Ansprüche,
mit wenigstens drei Anschlussstellen (2).

11. Optoelektronisches Bauteil gemäß dem vorherigen Anspruch, bei dem zumindest zwei Anschlussstellen (2) mit dem Kühlkörper (4) verschweißt sind.

12. Optoelektronisches Bauteil gemäß einem der vorherigen Ansprüche,
mit wenigstens vier optoelektronischen Halbleiterchips (5).

13. Verfahren zur Herstellung eines optoelektronischen Bauteils gemäß einem der vorherigen Ansprüche mit folgenden Schritten in folgender Reihenfolge:
- Bereitstellen von zumindest zwei Anschlussstellen (2),
- mechanisch fest Verbinden von zumindest einer Anschlussstelle (2) mit eine Kühlköper (4), wobei sich der Kühlkörper (4) in einer ersten Ebene erstreckt,
- Erzeugen eines Gehäusekörpers (3), in welchem die Anschlussstellen (2) stellenweise eingebettet sind, wobei im Gehäusekörper (3) eine Öffnung (30) zum Kühlkörper (4) vorgesehen wird, und
- Befestigung zumindest eines optoelektronischen Halbleiterchips (5) in der Öffnung (30) des Gehäusekörpers (3) auf dem Kühlkörper (4), wobei zumindest zwei der Anschlussstellen (2) je einen chipseitigen Abschnitt (2c) aufweisen, der dem zumindest einen optoelektronischen Halbleiterchip (5) zugewandt ist, und die chipseitigen Abschnitte (2c) der zumindest zwei Anschlussstellen (2) vertikal über und mit dem Kühlkörper (4) zumindest teilweise überlappend in einer gemeinsamen zweiten Ebene angeordnet sind, wobei die zweite Ebene von der ersten Ebene verschieden ist.

14. Verfahren gemäß dem vorherigen Anspruch,
bei dem die Anschlussstellen (2) im Trägerstreifen-Verbund vorliegen.

## Claims

1. An optoelectronic component (1) having
- at least two connecters (2) for electrical contacting of the component (1),
- a housing body (3), in which the connecters (2) are partially embedded,
- a heat sink (4), which is connected mechanically solid to at least one of the connecters (2), wherein
- the heat sink (4) extends in a first plane,
- the housing body (3) is formed of a plastics material,
- the housing body (3) comprises an opening (30), in which the heat sink (4) is freely accessible in places,
- at least one optoelectronic semiconductor chip (5) is arranged in the opening (30) on the heat sink (4), and
- at least two of the connecters (2) each comprise a chip-end portion (2c), which faces the at least one optoelectronic semiconductor chip (5), wherein the chip-end portions (2c) of at least two of the connecters (2) are arranged vertically above and at least partially overlapping with the heat sink (4) in a common second plane, wherein the second plane is different from the first plane and wherein the heat sink (4) comprises:
- a top face (41), on which the at least one optoelectronic semiconductor chip (5) is placed,
- a bottom face (42), remote from the top face (41), and
- a side face (43), which connects together the top face (41) and the bottom face (42), wherein the side face (43) is free of the plastics material of the housing body (3).

2. An optoelectronic component according to the preceding claim,
in which the plastics material of the housing body (3) is epoxy resin or contains epoxy resin.

3. An optoelectronic component according to either one of the preceding claims,
in which the plastics material of the housing body (3) is silicone or contains silicone.

4. An optoelectronic component according to any one of the preceding claims,
in which the heat sink (4) is a plate-like body consisting of a ceramic material or a doped semiconductor material.

5. An optoelectronic component according to any one of the preceding claims,
in which the heat sink (4) projects laterally beyond the housing body (3) in a fastening portion (44) of the heat sink (4) .

6. An optoelectronic component according to the preceding claim,
in which the heat sink (4) comprises an opening (45) in the fastening portion (44), which opening is intended for accommodating a fastening means (6).

7. An optoelectronic component according to any one of the preceding claims,
in which at least one of the connecters (2) is configured in a connecting portion (2a) remote from its chip-end portion (2c) as a soldering lug.

8. An optoelectronic component according to any one of the preceding claims,
in which at least one of the connecters (2) is configured in a connecting portion (2a) remote from its chip-end portion (2c) as a plug for a plug-and-socket connection.

9. An optoelectronic component according to any one of the preceding claims,
in which the at least one of the connecters (2) extends in its connecting portion (2a) transversely of the fastening portion (44) of the heat sink (4).

10. An optoelectronic component according to any one of the preceding claims,
having at least three connecters (2).

11. An optoelectronic component according to the preceding claim,
in which at least two connecters (2) are welded together with the heat sink (4).

12. An optoelectronic component according to any one of the preceding claims,
having at least four optoelectronic semiconductor chips (5).

13. A method of producing an optoelectronic semiconductor component according to one of the preceding claims, comprising the following steps in the following sequence:
- providing at least two connecters (2),
- connecting at least one connecter (2) mechanically solid to a heat sink (4), wherein the heat sink (4) extends in a first plane,
- producing a housing body (3), in which the connecters (2) are partially embedded, an opening (30) to the heat sink (4) being provided in the housing body (3), and
- fastening at least one optoelectronic semiconductor chip (5) on the heat sink (4) in the opening (30) in the housing body (3), wherein at least two of the connecters (2) each comprise a chip-end portion (2c), which faces the at least one optoelectronic semiconductor chip (5), wherein the chip-end portions (2c) of the at least two connecters (2) are arranged vertically above and at least partially overlapping with the heat sink (4) in a common second plane, wherein the second plane is different from the first plane.

14. A method according to the preceding claim,
in which the connecters (2) are present in the carrier strip assembly.

## Revendications

1. Composant optoélectronique (1) comportant
- au moins deux points de raccordement (2) pour la mise en contact électrique du composant (1),
- un corps de boîtier (3) dans lequel les points de raccordement (2) sont intégrés par endroits,
- un dissipateur thermique (4) qui est relié mécaniquement de façon fixe à au moins un des points de raccordement (2), **caractérisé en ce que**
- le dissipateur thermique (4) s'étend sur un premier plan,
- le corps de boîtier (3) est formé d'une matière synthétique,
- le corps de boîtier (3) présente un orifice (30) dans lequel le dissipateur thermique (4) est accessible librement par endroits,
- au moins une puce à semi-conducteurs optoélectronique (5) est disposée dans l'orifice (30) sur le dissipateur thermique (4), et **en ce que**
- au moins deux des points de raccordement (2) présentent respectivement un segment côté puce (2c) orienté vers ladite au moins une puce à semi-conducteurs optoélectronique (5), les segments côté puce (2c) d'au moins deux des points de raccordement (2) étant disposés verticalement au-dessus du dissipateur thermique (4) et le chevauchant au moins en partie dans un deuxième plan commun, le deuxième plan étant différent du premier plan et le dissipateur thermique (4) présentant :
- une surface supérieure (41) sur laquelle ladite au moins une puce à semi-conducteurs optoélectronique (5) est appliquée,
- une surface de base (42) opposée à la surface supérieure (41) et
- une surface latérale (43) qui relie entre elles la surface supérieure (41) et la surface de base (42), la surface latérale (43) étant dégagée de la matière synthétique du corps de boîtier (3).

2. Composant optoélectronique selon la revendication précédente, dans lequel la matière synthétique du corps de boîtier (3) est de la résine époxy ou contient de la résine époxy.

3. Composant optoélectronique selon l'une quelconque des revendications précédentes,
dans lequel la matière synthétique du corps de boîtier (3) est du silicone ou contient du silicone.

4. Composant optoélectronique selon l'une quelconque des revendications précédentes,
dans lequel le dissipateur thermique (4) est un corps en forme de plaque se composant d'un matériau céramique ou d'un matériau semi-conducteur dopé.

5. Composant optoélectronique selon l'une quelconque des revendications précédentes,
dans lequel le dissipateur thermique (4) surplombe latéralement le corps de boîtier (3) dans un segment de fixation (44) du dissipateur thermique (4).

6. Composant optoélectronique selon la revendication précédente, dans lequel le dissipateur thermique (4) présente dans le segment de fixation (44) un orifice (45) qui est prévu pour recevoir un moyen de fixation (6).

7. Composant optoélectronique selon l'une quelconque des revendications précédentes,
dans lequel au moins un des points de raccordement (2) est configuré sous la forme d'une queue à souder dans un segment de raccordement (2a) détourné de son segment côté puce (2c).

8. Composant optoélectronique selon l'une quelconque des revendications précédentes,
dans lequel au moins un des points de raccordement (2) est configuré sous la forme d'une fiche pour connexion par fiche dans un segment de raccordement (2a) détourné de son segment côté puce (2c).

9. Composant optoélectronique selon l'une quelconque des revendications précédentes,
dans lequel ledit au moins un des points de raccordement (2) s'étend dans son segment de raccordement (2a) transversalement par rapport au segment de fixation (44) du dissipateur thermique (4).

10. Composant optoélectronique selon l'une quelconque des revendications précédentes,
comportant au moins trois points de raccordement (2).

11. Composant optoélectronique selon la revendication précédente, dans lequel au moins deux points de raccordement (2) sont soudés au dissipateur thermique (4).

12. Composant optoélectronique selon l'une quelconque des revendications précédentes,
comportant au moins quatre puces à semi-conducteurs (5).

13. Procédé pour l'obtention d'un composant optoélectronique selon l'une quelconque des revendications précédentes, comportant les étapes suivantes dans l'ordre suivant :
- prévoir au moins deux points de raccordement (2), relier mécaniquement de façon fixe au moins un point de raccordement (2) à un dissipateur thermique (4), le dissipateur thermique (4) s'étendant sur un premier plan,
- fabriquer un corps de boîtier (3) dans lequel les points de raccordement (2) sont intégrés par endroits, un orifice (30) orienté vers le dissipateur thermique (4) étant prévu dans le corps de boîtier (3), et
- fixer au moins une puce à semi-conducteurs optoélectronique (5) dans l'orifice (30) du corps de boîtier (3) sur le dissipateur thermique (4), au moins deux des points de raccordement (2) présentant chacun un segment côté puce (2c) orienté vers ladite au moins une puce à semi-conducteurs optoélectronique (5), et les segments côté puce (2c) d'au moins deux des points de raccordement (2) étant disposés verticalement au-dessus du dissipateur thermique (4) et le chevauchant au moins en partie dans un deuxième plan commun, le deuxième plan étant différent du premier plan.

14. Procédé selon la revendication précédente, dans lequel les points de raccordement (2) se trouvent dans la liaison de bande de support.
